# EUROPEAN PATENT APPLICATION

(11) **EP 2 814 189 A1**
(43) Date of publication of application: **17.12.2014**
(21) Application number: 13746390.7
(22) Date of filing: 31.01.2013
(51) Int. Cl.: H04B 14/00, H01L 21/822, H01L 27/04, H04B 1/38

(54) **SIGNAL PROCESSING DEVICE**

(30) Priority: 08.02.2012 US 201213368838
(71) Applicant: Sony Corporation, Tokyo 108-0075 (JP)
(72) Inventor: KAWASAKI Kenichi, Tokyo 108-0075 (JP); TANAKA Yusuke, Tokyo 108-0075 (JP); YAMAGISHI Hiroyuki, Tokyo 108-0075 (JP); HAJIMIRI Ali, La Canada Flintridge, California 91011 (US)
(74) Representative: MFG Patentanwälte Meyer-Wildhagen Meggle-Freund Gerhard PartG mbB
(86) International application number: PCT/JP2013/052176
(87) International publication number: WO 2013/118631

(57) **Abstract**

The present technology relates to a signal processing device which can reduce a manufacturing cost. An electronic apparatus includes a semiconductor chip as a plurality of signal processing circuits. The semiconductor chip includes an input/output circuit (I/O) configured by one or both of an input circuit which functions as an input interface of a signal occupying a predetermined frequency band, and an output circuit which functions as an output interface of the signal occupying the predetermined frequency band. The signal occupying the predetermined frequency band is transmitted between the semiconductor chip and another semiconductor chip. The signal occupying the predetermined frequency band can be transmitted between the input/output circuit of one semiconductor chip and the input/output circuit of another semiconductor chip through any of a plurality of transmission media having different characteristics such as a metallic wire, a dielectric waveguide, and free space. The present technology can be applied to an electronic apparatus configured by a plurality of semiconductor chips, for example.

## Description

### TECHNICAL FIELD

The present technology relates to a signal processing device, particularly to a signal processing device which can reduce the cost of manufacturing an IC (Integrated Circuit), for example.

### BACKGROUND ART

A substrate on which an IC (including LSI (Large Scale Integration)) is mounted is housed in a casing of an electronic apparatus.

A recent IC is fabricated as an SoC (System on Chip), with which the versatility is lost but a reduced occupancy area, increased speed, and lower power consumption can be realized as compared with a case where a series of functions is realized by using a plurality of general-purpose semiconductor chips.

An electronic apparatus uses a metallic wire being a conductor made of metal, for example, as a transmission medium which transmits data between an IC and another IC on the same substrate or an IC on another substrate. Such IC thus uses an input/output interface, which exchanges a signal through the metallic wire, as an input/output interface to exchange a signal with an external circuit.

In performing communication (data transmission) through the metallic wire, the arrangement of the IC on the substrate or the arrangement of the substrate in the casing of the electronic apparatus may be restricted by how the metallic wire is wired.

Accordingly, there is proposed a signal processing device which transmits a signal between circuits by means of wireless communication through free space (refer to Patent Document 1, for example).

Compared with the communication performed through the metallic wire, the wireless communication performed through the free space allows the IC on the substrate or the substrate in the casing of the electronic apparatus to be arranged more freely.

### CITATION LIST

### PATENT DOCUMENT

Patent Document 1: JP 2003-179821 A

### SUMMARY OF THE INVENTION

### PROBLEMS TO BE SOLVED BY THE INVENTION

A circuit such as the IC transmitting a signal by the wireless communication through the free space uses an input/output interface which exchanges a signal by the wireless communication through the free space, for example.

This means that, when the IC using the input/output interface that exchanges a signal through the metallic wire is requested to exchange a signal by the wireless communication through the free space in view of the arrangement of the IC on the substrate, for example, the IC including the input/output interface needs to be re-fabricated, resulting in the increased manufacturing cost.

The re-fabrication of the IC as described above can take place when a characteristic of the transmission medium is to be changed in addition to when a type of the transmission medium is to be changed, in which case the transmission medium used by the IC to exchange a signal is changed from the metallic wire to the free space, for example.

The present technology is made in consideration of such condition, and is adapted to be able to reduce the manufacturing cost by preventing re-fabrication of a circuit such as the IC.

### SOLUTIONS TO PROBLEMS

A signal processing device according to an aspect of the present technology is a signal processing device including a plurality of signal processing circuits, wherein the signal processing circuit includes an input/output circuit configured by one or both of an input circuit which functions as an input interface of a signal occupying a predetermined frequency band, and an output circuit which functions as an output interface of a signal occupying the predetermined frequency band, the signal occupying the predetermined frequency band is transmitted between the signal processing circuit and another signal processing circuit, each of the output circuit of one signal processing circuit and the output circuit of another signal processing circuit includes a circuit having the same configuration, each of the input circuit of the one signal processing circuit and the input circuit of the another signal processing circuit includes a circuit having another same configuration, and the signal occupying the predetermined frequency band can be transmitted between the input/output circuit of the one signal processing circuit and the input/output circuit of the another signal processing circuit through any of a plurality of transmission media each having a different characteristic.

The signal processing circuit of the aforementioned signal processing device includes an input/output circuit configured by one or both of an input circuit which functions as an input interface of a signal occupying a predetermined frequency band, and an output circuit which functions as an output interface of a signal occupying the predetermined frequency band. The signal occupying the predetermined frequency band is transmitted between the signal processing circuit and another signal processing circuit. Each of the output circuit of one signal processing circuit and the output circuit of another signal processing circuit includes a circuit having the same configuration, while each of the input circuit of one signal processing circuit and the input circuit of another signal processing circuit includes a circuit having another same configuration, whereby the signal occupying the predetermined frequency band can be transmitted between the input/output circuit of the one signal processing circuit and the input/output circuit of the another signal processing circuit through any of a plurality of transmission media having different characteristics.

### EFFECTS OF THE INVENTION

According to one aspect of the present technology, the manufacturing cost can be reduced by preventing re-fabrication of a circuit.

### BRIEF DESCRIPTION OF DRAWINGS

Fig. 1 is a block diagram illustrating an example of a configuration of an input/output circuit according to an embodiment to which the present technology is applied.
Fig. 2 is a block diagram illustrating an example of a configuration of a transmission unit 101ᵢ.
Fig. 3 is a block diagram illustrating an example of a configuration of a reception unit 213ᵢ.
Fig. 4 is a schematic diagram illustrating an example of a configuration of an RF amplifier that can be used as an amplifier 73ᵢ and an amplifier 81ᵢ.
Fig. 5 is a diagram illustrating a transmission medium that can be used by input/output circuits 1 and 2 in data transmission.
Fig. 6 is a diagram illustrating a transmission characteristic of each of a metallic wire (Copper line), a dielectric waveguide (Plastic waveguide), and free space (Free space) serving as a transmission medium.
Fig. 7 is a perspective view illustrating an example of a configuration of an electronic apparatus as a signal processing device according to an embodiment to which the present technology is applied.
Fig. 8 is a cross-sectional view illustrating a first example of an arrangement of a chip configuring an electronic apparatus.
Fig. 9 is a cross-sectional view illustrating a second example of the arrangement of the chip configuring the electronic apparatus.
Fig. 10 is a cross-sectional view illustrating a third example of the arrangement of the chip configuring the electronic apparatus.
Fig. 11 is a cross-sectional view illustrating a fourth example of the arrangement of the chip configuring the electronic apparatus.
Fig. 12 is a cross-sectional view illustrating a method of testing the chip that has an input/output circuit configured similarly to the input/output circuit 1.
Figs. 13A and 13B are cross-sectional views illustrating how a chip 2110 is implemented after a non-invasive test is performed.
Fig. 14 is a cross-sectional view illustrating a method of testing the chip 2110 after being implemented.
Fig. 15 is a diagram illustrating a method of performing a loop-back test on the chip 2110.
Fig. 16 is a diagram illustrating a method of performing the loop-back test on the chip 2110.
Fig. 17 is a diagram illustrating a method of performing the loop-back test on the chip 2110.

### MODE FOR CARRYING OUT THE INVENTION

### [Input/output circuit to which present technology is applied]

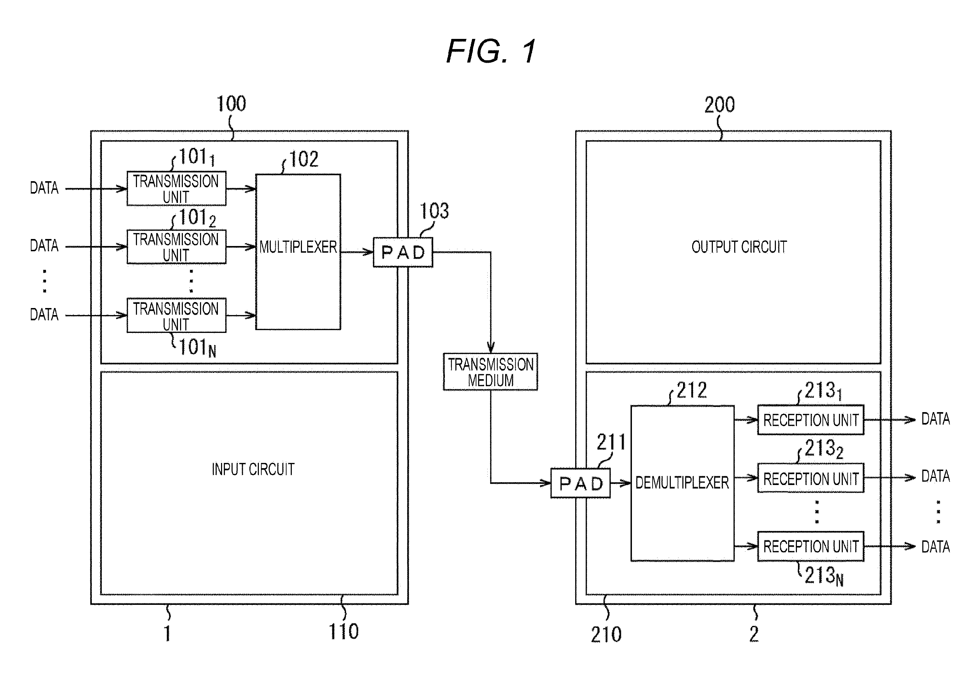

Fig. 1 is a block diagram illustrating an example of a configuration of an input/output circuit according to an embodiment to which the present technology is applied.

Each of input/output circuits 1 and 2 in Fig. 1 is configured on a semiconductor chip such as a CMOS (Complementary Metal Oxide Semiconductor) chip, where the semiconductor chip functions as an interface to exchange a signal with the outside.

It is now assumed that each of the input/output circuits 1 and 2 is configured on a different semiconductor chip, for example.

The input/output circuit 1 includes an output circuit 100 and an input circuit 110.

The output circuit 100 includes one or more transmission units 101₁, 101₂, ... , 101_{N}, a multiplexer 102, and a pad (PAD) 103, and functions as an output interface which outputs a signal in a predetermined frequency band such as a signal in a high-frequency band to the outside.

That is, serial data or the like that is a baseband signal is supplied to a transmission unit 101ᵢ from a circuit (not shown) in the semiconductor chip on which the input/output circuit 1 is configured.

The transmission unit 101ᵢ performs frequency conversion on the serial data that is the baseband signal, and outputs a converted signal that is a signal in a high-frequency band.

The transmission unit 101ᵢ therefore functions as a conversion circuit which performs frequency conversion to convert the baseband signal to the converted signal that is the signal in the high-frequency band.

The converted signal being output from the transmission unit 101ᵢ is supplied to the multiplexer 102.

The multiplexer 102 composes (multiplexes) the converted signal output from each of the transmission units 101₁ to 101_{N} and outputs a composite signal.

Where fsᵢ represents a center frequency of the frequency band of the converted signal that is output from the transmission unit 101ᵢ, the multiplexer 102 can be configured by a BPF (Band Pass Filter) which restricts the frequency band, with the center frequency fsᵢ, of the converted signal being output from the transmission unit 101ᵢ to a predetermined bandwidth, and a connection point which connects a connection line on the output of N pieces of BPFs each restricting the frequency band of the converted signal output from each of the transmission units 101₁ to 101_{N}, for example.

Now, where BPF #i among the N pieces of BPFs configuring the multiplexer 102 represents the BPF that restricts the frequency band, with the center frequency fsᵢ, of the converted signal being output from the transmission unit 101ᵢ, the multiplexer 102 is configured by N pieces of BPF#1 to #N and the connection point which connects the connection line on the output of each of the N pieces of BPF #1 to #N, in which case the BPF #i restricts the frequency band of the converted signal being output from the transmission unit 101ᵢ and, after that, the converted signal being output from each of the N pieces of BPF #1 to #N is composed at the connection point which connects the connection line on the output of each of the N pieces of BPF #1 to #N.

The composite signal being output from the multiplexer 102, namely a signal generated by multiplexing frequency of the converted signal output from each of the transmission units 101₁ to 101_{N}, is then output from the pad 103 to be transmitted through a predetermined transmission medium.

Serial data obtained in the semiconductor chip on which the input/output circuit 1 is configured is transmitted as a composite signal to another semiconductor chip such as a semiconductor chip on which the input/output circuit 2 is configured.

The input circuit 110 has a configuration similar to that of an input circuit 210 (to be described) of the input/output circuit 2 that is another input/output circuit (when seen from the input/output circuit 1).

The input/output circuit 2 includes an output circuit 200 and the input circuit 210.

The output circuit 200 has a configuration similar to that of the output circuit 100 of the input/output circuit 1 that is another input/output circuit (when seen from the input/output circuit 2).

The input circuit 210 includes a pad 211, a demultiplexer 212, and one or more reception units 213₁, 213₂, ... , 213_{N}, and functions as an input interface which accepts input of a signal in a predetermined frequency band such as a signal in a high-frequency band.

That is, the composite signal transmitted through the predetermined transmission medium is input (supplied) to the pad 211 so that the composite signal being input to the pad 211 is supplied to the demultiplexer 212.

The demultiplexer 212 distributes to each of the reception units 213₁ to 213_{N} at least the converted signal in a frequency band that is subjected to the frequency conversion to be performed by a reception unit 213ᵢ, the converted signal being included in the composite signal supplied to the demultiplexer.

Where frᵢ represents a center frequency of the frequency band of the converted signal subjected to the frequency conversion by the reception unit 213ᵢ which converts the converted signal into the baseband signal, the demultiplexer 212 distributes to the reception unit 213ᵢ at least the converted signal with the center frequency frᵢ that is included in the composite signal transmitted from the pad 211.

The demultiplexer 212 as described above can be configured by a BPF which extracts, from the composite signal, the converted signal with the center frequency frᵢ that is subjected to the frequency conversion by the reception unit 213ᵢ, and a connection point which connects a connection line on the input to N pieces of BPFs corresponding to each of the reception units 213₁ to 213_{N}.

Now, where BPF' #i among the N pieces of BPFs configuring the demultiplexer 212 represents the BPF that extracts the converted signal with the center frequency frᵢ, the demultiplexer 212 is configured by N pieces of BPF'#1 to #N and the connection point which connects the connection line on the input of each of the N pieces of BPF' #1 to #N, in which case the composite signal is supplied to each of the N pieces of BPF' #1 to #N from the connection point connecting the connection line on the input of each of the N pieces of BPF' #1 to #N. The BPF' #i then extracts the converted signal with the center frequency frᵢ to be supplied (distributed) to the reception unit 213ᵢ.

Note that the frequency fsᵢ of the converted signal handled by the transmission unit 101ᵢ is equal to the frequency frᵢ of the converted signal handled by the reception unit 213ᵢ when data transmitted from the input/output circuit 1 is received by the input/output circuit 2.

The reception unit 213ᵢ performs frequency conversion on the converted signal with the center frequency frᵢ that is distributed from the demultiplexer 212, and outputs serial data that is a baseband signal.

The reception unit 213ᵢ therefore functions as an inverse conversion circuit which performs frequency conversion to convert the converted signal that is the signal in the high-frequency band into the baseband signal.

The serial data being output from the reception unit 213ᵢ is supplied to a circuit (not shown) in the semiconductor chip on which the input/output circuit 2 is configured.

As described above, the semiconductor chip on which the input/output circuit 2 is configured receives the serial data that is transmitted as the composite signal from another semiconductor chip such as the semiconductor chip on which the input/output circuit 1 is configured.

Note that the frequency fsᵢ of the converted signal handled by the transmission unit 101ᵢ is different from frequency fsᵢ, of the converted signal handled by another transmission unit 101_{i'} (I # i'). The same can be said of the frequency frᵢ of the converted signal handled by the reception unit 213ᵢ.

Moreover, the input/output circuit 1 can be configured solely by the output circuit 100 or the input circuit 110. Likewise, the input circuit 2 can be configured solely by the output circuit 200 or the input circuit 210.

The input/output circuit 1 can be configured solely by the output circuit 100 and the input circuit 2 solely by the input circuit 210, when data is only transmitted from the semiconductor chip on which the input/output circuit 1 is configured to the semiconductor chip on which the input/output circuit 2 is configured, for example.

When provided with only one transmission unit 101₁, the output circuit 100 can be configured without the multiplexer 102. Likewise, the input circuit 210 can be configured without the demultiplexer 212 when the input circuit 210 is provided with only one reception unit 213₁. The number N of the transmission units 101₁ to 101_{N} provided in the output circuit 100 as well as the number N of the reception units 213₁ to 213_{N} provided in the input circuit 210 are based on a data rate or the like of the data transmitted from the output circuit 100 to the input circuit 210, and are set to enable data transmission at the data rate.

Here, the input circuit 110 of the input/output circuit 1 has the configuration similar to that of the input circuit 210 of the input/output circuit 2, and thus includes a pad (not shown) similar to the pad 211 included in the input circuit 210. One pad can serve both as the pad 103 included in the output circuit 100 and the pad (not shown) included in the input circuit 110 in the input/output circuit 1. The same can be said of the input/output circuit 2.

### [Example of configuration of transmission unit 101ᵢ]

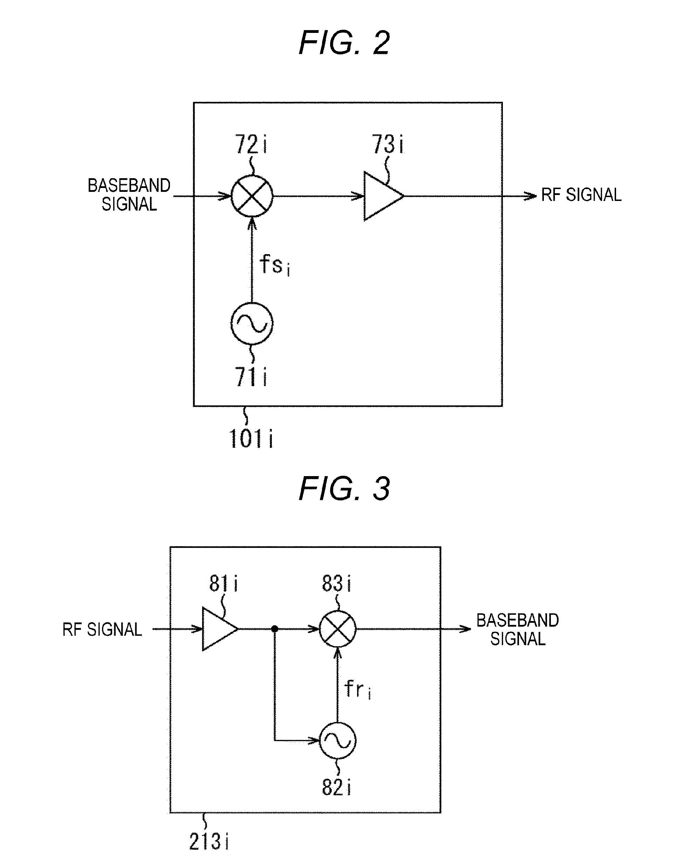

Fig. 2 is a block diagram illustrating an example of a configuration of the transmission unit 101ᵢ illustrated in Fig. 1.

The transmission unit 101ᵢ performs frequency conversion to convert (up-convert) a baseband signal into a signal in a millimeter wave band, for example.

Note that the signal in the millimeter wave band is a signal having the frequency of approximately 30 to 300 GHz, or the wavelength of approximately 1 to 10 mm. The signal in the millimeter wave band having high frequency enables data transmission at a high rate and, when data is transmitted/received wirelessly, a bonding wire with the diameter of approximately 1 mm can be used as an antenna.

The transmission unit 101ᵢ includes an oscillator 71ᵢ, a mixer 72ᵢ, and an amplifier 73ᵢ.

The oscillator 71ᵢ generates a carrier in the millimeter wave band by oscillation, for example, and supplies the carrier to the mixer 72ᵢ.

The center frequency fsᵢ of the converted signal output from the transmission unit 101ᵢ corresponds to the frequency of the carrier generated by the oscillator 71ᵢ of the transmission unit 101ᵢ.

In addition to the carrier generated by the oscillator 71ᵢ, serial data that is a baseband signal is supplied to the mixer 72ᵢ.

Where a data rate of the serial data supplied to the mixer 72ᵢ is approximately 2.5 to 5.0 Gbps, for example, it is desired that the frequency of the carrier generated by the oscillator 71ᵢ be higher than or equal to 30 GHz or the like in order to reduce interference between converted signals obtained by the frequency conversion performed on the serial data by each of the transmission units 101₁ to 101_{N} and to be able to separate each converted signal from the composite signal obtained by composing the converted signals.

The mixer 72ᵢ mixes (multiplies) the serial data and the carrier from the oscillator 71ᵢ to modulate the carrier from the oscillator 71ᵢ according to the serial data, and supplies to the amplifier 73ᵢ a resultant modulated signal, namely, a converted signal obtained by the frequency conversion converting the serial data that is the baseband signal into an RF (Radio Frequency) signal in a frequency band corresponding to the carrier supplied from the oscillator 71ᵢ.

The amplifier 73ᵢ amplifies the RF signal as the converted signal supplied from the mixer 72ᵢ, and outputs the amplified RF signal as the converted signal.

The converted signal output from the amplifier 73ᵢ is then supplied to the multiplexer 102 (Fig. 1).

### [Example of configuration of reception unit 213ᵢ]

Fig. 3 is a block diagram illustrating an example of a configuration of the reception unit 213ᵢ illustrated in Fig. 1.

The reception unit 213ᵢ performs frequency conversion to inversely convert (down-convert) the signal in the millimeter wave band into the baseband signal, for example.

The reception unit 213ᵢ includes an amplifier 81ᵢ, an oscillator 82ᵢ, and a mixer 83ᵢ.

The demultiplexer 212 (Fig. 1) supplies to the amplifier 81ᵢ at least the RF signal including the converted signal in the frequency band that is to be subjected to the frequency conversion by the reception unit 213ᵢ.

The amplifier 81ᵢ amplifies the RF signal supplied thereto and supplies, to the oscillator 82ᵢ and the mixer 83ᵢ, a resultant RF signal as a converted signal in the frequency band that is to be subjected to the frequency conversion by the reception unit 213ᵢ.

The oscillator 82ᵢ operates the converted signal (RF signal) from the amplifier 81ᵢ as an injection signal to generate, by means of oscillation, a recovered carrier in sync with (the carrier of) the converted signal as the injection signal, namely, a recovered carrier corresponding to the carrier used in the frequency conversion of the converted signal, and supplies the recovered carrier to the mixer 83ᵢ.

The mixer 83ᵢ mixes (multiplies) the converted signal from the amplifier 81ᵢ and the recovered carrier from the oscillator 82ᵢ to demodulate the converted signal (modulated signal) and output a resultant demodulated signal, namely, the serial data obtained by the frequency conversion in which the converted signal is converted into the baseband signal.

Note that the reception unit 213ᵢ in Fig. 3 performs the frequency conversion to convert the converted signal into the baseband signal by employing synchronous detection which multiplies the RF signal and the recovered carrier to detect the RF signal as well as injection locking which uses the RF signal as the injection signal to generate the recovered carrier used in the synchronous detection. However, the reception unit 213ᵢ can also perform the frequency conversion by employing square law detection to detect the RF signal or employing synchronous detection to detect the RF signal and PLL (Phase Lock Loop) to generate the recovered carrier used in the synchronous detection, for example.

### [Example of configuration of amplifiers 73ᵢ and 81ᵢ]

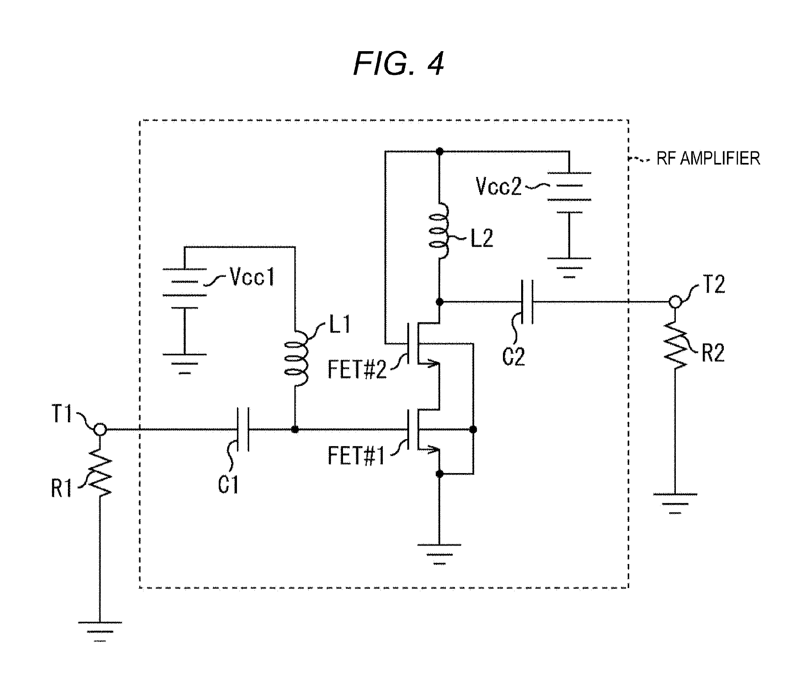

Fig. 4 is a schematic diagram illustrating an example of a configuration of an RF amplifier that can be used as the amplifier 73ᵢ in Fig. 2 and the amplifier 81ᵢ in Fig. 3.

Each of the amplifiers 73ᵢ and 81ᵢ is the RF amplifier amplifying an RF signal and can thus be configured in the same manner.

As illustrated in Fig. 4, an input terminal T1 of the RF amplifier is connected to one end of a capacitor C1, another end of which is connected to one end of a coil L1. Another end of the coil L1 is connected to a positive terminal of a DC power source Vcc1, a negative terminal of which is connected to ground.

A connection point between the capacitor C1 and the coil L1 is connected to a gate of an FET (MOS FET) #1, a source of which is connected to ground.

A drain of the FET #1 is connected to a source of an FET (MOS FET) #2, while a gate and a drain of the FET #2 are connected to one end and another end of a coil L2, respectively.

Note that a substrate of each of the FETs #1 and #2 is connected to ground.

A connection point between the gate of the FET #2 and the coil L2 is connected to a positive terminal of a DC power source Vcc2, a negative terminal of which is connected to ground.

A connection point between the drain of the FET #2 and the coil L2 is connected to one end of a capacitor C2, another end of which is connected to an output terminal T2 of the RF amplifier.

The RF amplifier illustrated in Fig. 4 can be connected in cascade for use, meaning that each of the amplifiers 73ᵢ and 81ᵢ can be configured by only one RF amplifier in Fig. 4 or by connecting a plurality of the RF amplifiers in Fig. 4 in cascade as needed.

Note that when the amplifier 73ᵢ or 81ᵢ is configured by only one RF amplifier in Fig. 4, the input terminal T1 and the output terminal T2 are connected to one ends of resistors R1 and R2, respectively, while another ends of the resistors are connected to ground.

In order to simplify the description, each of the amplifiers 73ᵢ and 81ᵢ is hereinafter configured by only one RF amplifier illustrated in Fig. 4.

Each of the amplifiers 73ᵢ and 81ᵢ is configured to amplify the RF signal in the millimeter wave band that is a high frequency signal, whereby the RF amplifier serving as such amplifiers 73ᵢ and 81ᵢ can employ inductance load as a load on an input side and an output side of the amplifier.

A coil with low inductance can be used as the inductance load for the millimeter wave band, where such coil can be easily configured on a CMOS.

In the RF amplifier illustrated in Fig. 4, the coil L1 corresponds to the inductance load on the input side whereas the coil L2 corresponds to the inductance load on the output side.

When the inductance load is used as the load on the input side of the RF amplifier, the frequency characteristic on the input side of the RF amplifier has a band-pass characteristic as that of a BPF so that a signal occupying a part of the frequency band can be separated from the RF signal being input (supplied) to the RF amplifier and be amplified.

When the inductance load is used as the load on the output side of the RF amplifier, the frequency characteristic on the output side of the RF amplifier has a band-pass characteristic as that of the BPF so that the frequency band of the RF signal being output from the RF amplifier can be restricted.

As described above, the RF amplifier employing the inductance load as the load on the input and output sides is used as the amplifiers 73ᵢ and 81ᵢ to have the frequency characteristic exhibiting the band-pass characteristic on the input and output sides, whereby the multiplexer 102 in the output circuit 100 and the demultiplexer 212 in the input circuit 210 can be simply configured by a connection point connecting the connection line without the BPF as described with reference to Fig. 1.

Note that the multiplexer 102 can be configured without the BPF when the frequency characteristic exhibits the band-pass characteristic on at least the output side of the input and output sides of the RF amplifier used as the amplifier 73ᵢ of the transmission unit 101ᵢ that is connected to the multiplexer 102.

Accordingly, the RF amplifier serving as the amplifier 73ᵢ of the transmission unit 101ᵢ connected to the multiplexer 102 can employ a load that is not the inductance load, namely, a resistor in place of the coil L1, on the input side of the amplifier.

Furthermore, the demultiplexer 212 can be configured without the BPF when the frequency characteristic exhibits the band-pass characteristic on at least the input side of the input and output sides of the RF amplifier used as the amplifier 81ᵢ of the reception unit 213ᵢ that is connected to the demultiplexer 212.

Accordingly, the RF amplifier serving as the amplifier 81ᵢ of the reception unit 213ᵢ connected to the demultiplexer 212 can employ a load that is not the inductance load, namely, a resistor in place of the coil L2, on the output side of the amplifier.

It is however desired that the inductance load be used as the load on the output side instead of the resistor, when a certain amount or more of the gain is required in the RF amplifier serving as the amplifier 81ᵢ of the reception unit 213ᵢ.

As a result, the output circuit 100 and the input circuit 210, and eventually the input/output circuits 1 and 2, can be configured smaller by configuring the multiplexer 102 and the demultiplexer 212 without the BPF.

### [Transmission medium used by input/output circuits 1 and 2 in data transmission]

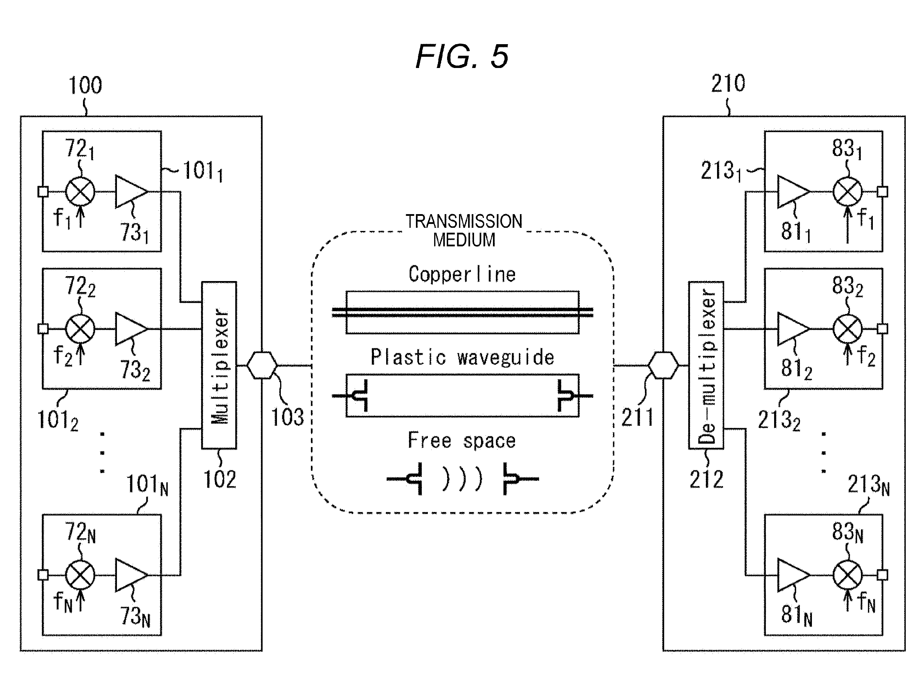

Fig. 5 is a diagram illustrating the transmission medium that can be used by the input/output circuits 1 and 2 in Fig. 1 to transmit data (such as to transmit data from the output circuit 100 of the input/output circuit 1 to the input circuit 210 of the input/output circuit 2).

The converted signal being the millimeter wave or the like is used (mediated) between the input/output circuits 1 and 2 to be able to transmit data therebetween via the transmission medium having a different characteristic (transmission characteristic) without re-fabricating the input/output circuits 1 and 2.

Specifically, for example, different types of transmission media including a metallic wire such as a copper line, a dielectric waveguide such as a plastic waveguide, and free space have different transmission characteristics, but data can be transmitted between the input/output circuits 1 and 2 via any one of these transmission media having the different transmission characteristics.

Note that the same type of transmission media may have different transmission characteristics. Transmission media having different transmission characteristics may either differ in types or have the same type.

A coplanar strip line is a transmission medium formed of the metallic wire and is a balanced transmission line (a transmission line passing a differential signal) formed of two strip-like conductors arranged in parallel, for example. Here, the coplanar strip line formed of two strip-like conductors that are cut partially and the coplanar strip line formed of two continuous strip-like conductors without being cut correspond to the transmission media that have the same type but differ in the transmission characteristics, for example.

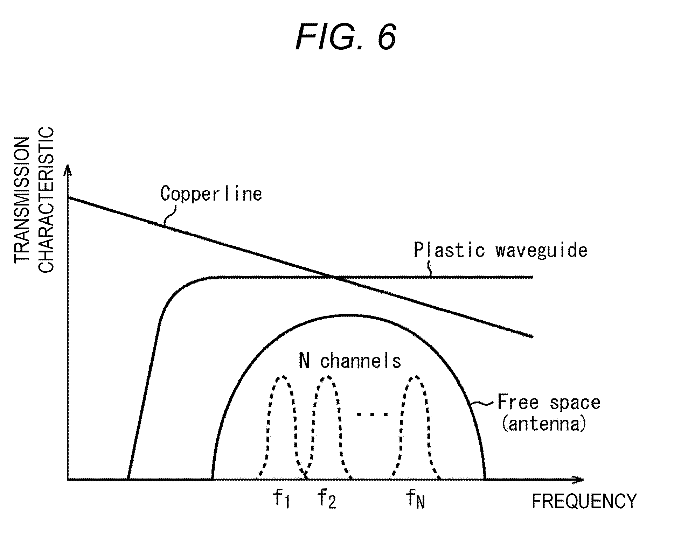

Fig. 6 is a diagram illustrating the transmission characteristic of each of the metallic wire (Copper line), the dielectric waveguide (Plastic waveguide), and the free space serving as the transmission medium.

Note that the coplanar strip line formed of two strip-like conductors with the length equal to approximately 25 mm from one end to another end thereof, for example, can be used as the metallic wire. The plastic waveguide having the length equal to approximately 120 mm from one end to another end thereof and the width equal to approximately 2 mm, for example, can be used as the dielectric waveguide. Space (in the air) of approximately 5 mm can be used as the free space, for example.

Fig. 6 schematically illustrates the transmission characteristic (amplitude characteristic) of each of the aforementioned metallic wire, dielectric waveguide, and free space.

The metallic wire has the transmission characteristic similar to that of a LPF (Low Pass Filter), the dielectric waveguide has the transmission characteristic similar to that of a HPF (High Pass Filter), and the free space has the transmission characteristic similar to that of the BPF.

The transmission characteristic of each of the metallic wire, the dielectric waveguide, and the free space serving as the transmission medium used in the data transmission between the input/output circuits 1 and 2 is a characteristic that passes a signal in the frequency band of at least 40 GHz to approximately 100 GHz, for example, as the millimeter wave frequency band used in the data transmission between the input/output circuits 1 and 2.

The frequency fsᵢ of the converted signal handled by the transmission unit 101ᵢ is equal to the frequency frᵢ of the converted signal handled by the reception unit 213ᵢ when data is transmitted between the input/output circuits 1 and 2, as described with reference to Fig. 1. Where the equal frequency is represented as fᵢ (= fsᵢ = frᵢ) and f₁, f₂, ... , f_{N} satisfy an expression f₁ < f₂ < ... < f_{N}, the frequency higher than 30 GHz is used as the frequency f₁ while the frequency lower than 300 GHz is used as the frequency f_{N}, for example.

Data can be transmitted between the input/output circuits 1 and 2 via the transmission medium having the different characteristic (transmission characteristic), so that the semiconductor chip on which the input/output circuits 1 and 2 are configured need not be re-fabricated even when the transmission medium used in the data transmission between the input/output circuits 1 and 2 is changed. As a result, the cost of manufacturing the semiconductor chip (and thus an electronic apparatus serving as a signal processing device that uses the semiconductor chip) can be reduced.

Moreover, each of the output circuit 100 of the input/output circuit 1 and the output circuit 200 of the input/output circuit 2 includes the transmission unit 101ᵢ as the circuit having the same configuration. Each of the input circuit 110 of the input/output circuit 1 and the input circuit 210 of the input/output circuit 2 includes the reception unit 213ᵢ as the circuit having another same configuration. Moreover, in Fig. 1, the output circuit 100 of the input/output circuit 1 and the output circuit 200 of the input/output circuit 2 have the same configuration, and the input circuit 110 of the input/output circuit 1 and the input circuit 210 of the input/output circuit 2 have the same configuration.

As described above, the input/output circuits 1 and 2 having the same configuration need not be subjected to a change in configuration for each transmission medium used in the data transmission and, as a result, can be mass-produced easily.

Note that when the dielectric waveguide or the free space is used as the transmission medium used in the data transmission between the input/output circuits 1 and 2, an antenna used to efficiently radiate the RF signal in the millimeter wave to the dielectric waveguide or the free space can be connected to the pads 103 and 211 as a coupler to be coupled with the transmission medium. A bonding wire with the length equal to 1/2 (or longer than) the wavelength λ of the millimeter wave or a coil (loop antenna) can be used as the antenna, for example.

For reasons of easiness to measure the RF signal in the millimeter wave through the pads 103 and 211 (a probe of a measuring instrument that measures the millimeter wave is adapted for a single-ended signal), a simplified configuration of a circuit on a CMOS chip, and achieving lower power consumption, one can expect a single-ended I/F exchanging a single-ended signal to be used as the transmission unit 101ᵢ outputting the millimeter wave and thus a circuit corresponding to a part of the output circuit 100 outputting the RF signal, and as the reception unit 213ᵢ receiving the input of the millimeter wave and thus a circuit corresponding to a part of the input circuit 210 to which the RF signal is input.

On the other hand, the coplanar strip line that is the metallic wire serving as the transmission medium is the balanced transmission line (differential transmission line) through which a differential signal is exchanged.

Accordingly, a circuit called a balun circuit performing conversion between the single-ended signal and the differential signal (balanced-to-unbalanced conversion) needs to be connected to the pads 103 and 211 when the coplanar strip line is used as the transmission medium between the output circuit 100 and the input circuit 210 employing the single-ended I/F.

When the balun is connected to the pads 103 and 211, however, an electronic apparatus configured by using the semiconductor chip that includes the input/output circuit 1 or 2 is increased in size and cost.

Now, when the coplanar strip line being the differential transmission line is used as the transmission medium, one of the two conductors configuring the coplanar strip line can be electrically and directly connected to the pad 103 (211) through which a signal component is exchanged, whereas another conductor can be electrically and directly connected to ground (GND) (not shown) of the output circuit 100 (input circuit 210).

In this case, the millimeter wave that is the single-ended signal being output from the pad 103 of the output circuit 100 is transmitted as a differential signal through the coplanar strip line (to the input circuit 210).

The data transmission using the single-ended signal may have degraded quality due to many unnecessary radiations and low immunity to noise from outside (outside the transmission line through which the single-ended signal is transmitted) as compared with the data transmission using the differential signal, but the data transmission in good quality can be performed by transmitting the single-ended signal as the differential signal.

Note that impedance of the differential transmission line is generally higher than impedance of the single-ended I/F but, when the impedance of the differential transmission line differ greatly from the impedance of the single-ended I/F, the data transmission in good quality may be hindered by the reflection caused by an impedance mismatch.

Now, when the coplanar strip line being the differential transmission line is used as the transmission medium, a dielectric material can be arranged on the coplanar strip line to reduce the impedance (characteristic impedance) of the coplanar strip line and realize an impedance match.

That is, the characteristic impedance of the coplanar strip line being the differential transmission line is reduced by decreasing capacitance. Accordingly, the capacitance and thus the characteristic impedance of the coplanar strip line can be decreased by arranging the dielectric material on the coplanar strip line being the differential transmission line.

In addition, when the coplanar strip line being the differential transmission line is used as the transmission medium, one conductor connected to the pad 103 (211) through which the signal component is exchanged, out of the two conductors configuring the coplanar strip line, can be connected to a short stub having the length of approximately λ/4.

The short stub functioning as a BPF can remove low frequency noise and also reduce common mode noise in the coplanar strip line to be able to improve a pass characteristic in a differential mode (normal mode).

### [Example of configuration of electronic apparatus to which present technology is applied]

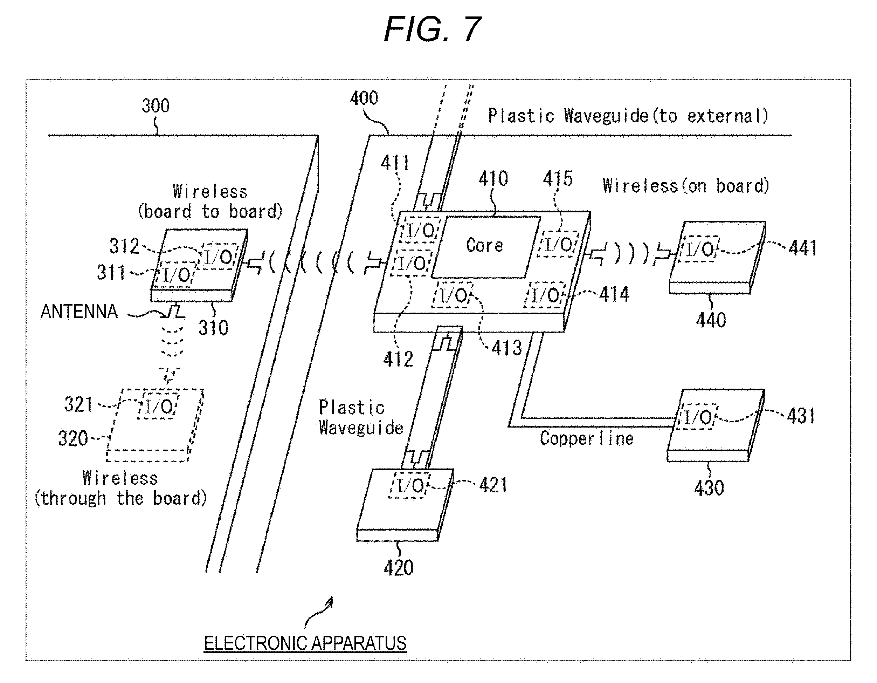

Fig. 7 is a perspective view illustrating an example of a configuration of the electronic apparatus serving as the signal processing device according to an embodiment to which the present technology is applied.

The electronic apparatus includes a plurality of substrates housed in the casing of the electronic apparatus. Fig. 7 illustrates two substrates 300 and 400 among the plurality of substrates housed in the casing of the electronic apparatus.

Each of the substrates numbered 300 and 400 is a flat printed board and is arranged side by side on a plane.

A semiconductor chip 310 (hereinafter simply referred to as a chip as well) serving as the signal processing circuit is mounted on a front surface of the substrate 300, while a chip 320 is mounted on a back surface that is on the opposite side of the front surface as illustrated by a dotted line in the figure.

The chip 310 includes (has built-in) input/output circuits (I/O) 311 and 312, while the chip 320 includes an input/output circuit 321.

Chips 410, 420, 430, and 440 are mounted on a front surface of the substrate 400.

The chip 410 includes input/output circuits 411, 412, 413, 414, and 415, the chip 420 includes an input/output circuit 421, the chip 430 includes an input/output circuit 431, and the chip 440 includes an input/output circuit 441.

As described above, the electronic apparatus serving as the signal processing device in Fig. 7 includes six (or more) of the chips 310, 320, and 410 to 440 as the plurality of signal processing circuits.

Each of the input/output circuits 311, 312, 321, 411 to 415, 421, 431, and 441 has the same configuration as the input/output circuit 1 (Fig. 1). As a result, the input/output circuits 311, 312, 321, 411 to 415, 421, 431, and 441 can perform data transmission with another input/output circuit through any of the plurality of transmission media such as the metallic wire, the dielectric waveguide, and the free space which have the different characteristics.

As illustrated in Fig. 7, each of the input/output circuit 311 of the chip 310 mounted on the front surface of the substrate 300 and the input/output circuit 321 of the chip 320 mounted on the back surface of the substrate 300 includes an antenna which is connected to a portion corresponding to the pads 103 and 211 illustrated in Fig. 1 to exchange radio waves through the free space.

Therefore, data transmission is performed between the input/output circuits 311 and 321 through the free space (Wireless) (through the substrate 300 serving as a dielectric waveguide when the substrate 300 is regarded as the dielectric waveguide).

Moreover, as illustrated in Fig. 7, each of the input/output circuit 312 of the chip 310 mounted on the substrate 300 and the input/output circuit 412 of the chip 410 mounted on the substrate 400 seen as another substrate (a substrate different from the substrate 300) includes an antenna which is connected to a portion corresponding to the pads 103 and 211 illustrated in Fig. 1 to exchange radio waves through the free space.

Therefore, the data transmission is performed between the input/output circuits 312 and 412 through the free space (Wireless).

Moreover, as illustrated in Fig. 7, the input/output circuit 411 of the chip 410 mounted on the substrate 400 includes an antenna which is connected to a portion corresponding to the pads 103 and 211 in Fig. 1 to efficiently exchange the millimeter wave as the RF signal with the dielectric waveguide such as the plastic waveguide.

The strip-like plastic waveguide connected to an external circuit (not shown) that is not on the substrate 400 (or the substrate 300) is arranged such that one end of the plastic waveguide comes in contact with the antenna connected to the input/output circuit 411.

Therefore, the data transmission is performed between the input/output circuit 411 of the chip 410 mounted on the substrate 400 and the external circuit (not shown) through the plastic waveguide serving as the dielectric waveguide.

Furthermore, as illustrated in Fig. 7, each of the input/output circuit 413 of the chip 410 mounted on the substrate 400 and the input/output circuit 421 of the chip 420 mounted on the substrate 400 includes an antenna which is connected to a portion corresponding to the pads 103 and 211 in Fig. 1 to efficiently exchange the millimeter wave as the RF signal with the dielectric waveguide such as the plastic waveguide.

The strip-like plastic waveguide is arranged such that one end thereof is in contact with the antenna connected to the input/output circuit 413 and another end is in contact with the antenna connected to the input/output circuit 421.

Therefore, the data transmission is performed between the input/output circuits 413 and 421 through the plastic waveguide serving as the dielectric waveguide.

Furthermore, as illustrated in Fig. 7, the input/output circuit 414 of the chip 410 mounted on the substrate 400 and the input/output circuit 431 of the chip 430 mounted on the substrate 400 include a metallic wire (Copper line) such as the coplanar strip line, one and another ends of which are connected to a portion corresponding to each of the pads 103 and 211 illustrated in Fig. 1.

Therefore, the data transmission is performed between the input/output circuits 414 and 431 through the metallic wire (Copper line) such as the coplanar strip line.

Furthermore, as illustrated in Fig. 7, each of the input/output circuit 415 of the chip 410 mounted on the substrate 400 and the input/output circuit 441 of the chip 440 mounted on the substrate 400 includes an antenna which is connected to a portion corresponding to each of the pads 103 and 211 in Fig. 1 to exchange radio waves through the free space.

Therefore, the data transmission is performed between the input/output circuits 415 and 441 through the free space (Wireless).

Although susceptible to interference from outside, the data transmission performed through the free space requires no wiring and thus can be used in data transmission between chips where wiring is difficult due to a layout or the like, for example.

While requiring disposal of a dielectric material with the width proportional to the wavelength of the millimeter wave that is the RF signal used in the data transmission, the data transmission performed through the dielectric waveguide can realize efficient transmission of the millimeter wave over a relatively long distance and can thus be used in data transmission between chips that are located relatively far from each other, for example.

Although the efficiency is decreased in data transmission over a relatively long distance where resistance cannot be ignored, the data transmission performed through the metallic wire requires a small wiring area and can concentrate the electric field of the millimeter wave within a small range, and can thus be used in data transmission between chips that are closely located to each other or chips having a number of wirings at small intervals, for example.

Each of the input/output circuits 311, 312, 321, 411 to 415, 421, 431, and 441 has the same configuration as the input/output circuit 1 (Fig. 1) and thus need not be re-fabricated when any of the free space, the dielectric waveguide, and the metallic wire is used as the transmission medium.

Accordingly, the chips 310, 320, and 410 to 440 need not be re-fabricated when any of the free space, the dielectric waveguide, and the metallic wire is used as the transmission medium.

Note that the transmission medium used between the chips is not limited to what is illustrated in Fig. 7 where: the free space is used as the transmission medium between the chips 310 and 320; the free space is used as the transmission medium between the chips 310 and 410; the plastic waveguide is used as the transmission medium between the chips 410 and 420; the metallic wire is used as the transmission medium between the chips 410 and 430; and the free space is used as the transmission medium between the chips 410 and 440.

In other words, the same transmission medium such as the free space can be used as the transmission medium for all data transmission performed between the chips 310 and 320, between the chips 310 and 410, between the chips 410 and 420, between the chips 410 and 430, and between the chips 410 and 440 illustrated in Fig. 7.

Moreover, the transmission medium between chips which are adapted to be provided with the plastic waveguide can be thereafter changed from the free space to the plastic waveguide, for example.

Here, the substrates 300 and 400 are housed in the casing of the electronic apparatus where the casing is a closed space, so to speak, whereby the communication environment hardly changes in the casing.

Therefore, there is so to speak constant interference in the data transmission performed through the free space in the casing,
which makes it relatively easy to take measures against the interference.

### [Example of chip arrangement]

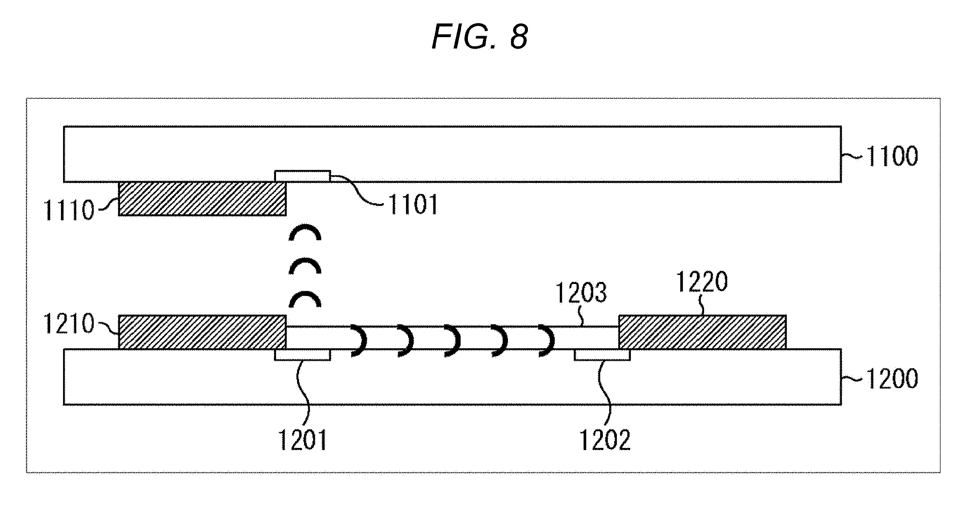

Fig. 8 is a cross-sectional view illustrating a first example of the arrangement of a chip configuring the electronic apparatus.

As illustrated in Fig. 8, flat substrates 1100 and 1200 are arranged in parallel with flat surfaces of the substrates facing each other.

A chip 1110 is mounted on a back surface opposite to a front surface of the substrate 1100.

The chip 1110 includes an input/output circuit (not shown) having the same configuration as the input/output circuit 1 (Fig. 1), and a coupler 1101 such as an antenna is connected to a portion corresponding to the pads 103 and 211 (Fig. 1) of the input/output circuit to efficiently radiate the millimeter wave to the free space and the dielectric waveguide.

Chips 1210 and 1220 are mounted on a front surface of the substrate 1200.

Each of the chips 1210 and 1220 includes an input/output circuit (not shown) having the same configuration as the input/output circuit 1 (Fig. 1).

Couplers 1201 and 1202 similar to the coupler 1101 are connected to a portion corresponding to the pads 103 and 211 (Fig. 1) of the input/output circuit included in the chips 1210 and 1220, respectively.

Then, there is arranged on the substrate 1200 a strip-like plastic waveguide 1203 such that one and another ends thereof come in contact with the couplers 1201 and 1202, respectively.

The chip 1110 on the substrate 1100 and the chip 1210 on the substrate 1200 are arranged such that the couplers 1101 and 1201 face each other.

As described above, the electronic apparatus in which the chips 1110, 1210, and 1220 are arranged performs data transmission by exchanging the millimeter wave between the chip 1110 on the substrate 1100 and the chip 1210 on the another substrate 1200 through the free space.

Moreover, the chips 1210 and 1220 on the substrate 1200 perform data transmission by exchanging the millimeter wave through the plastic waveguide 1203.

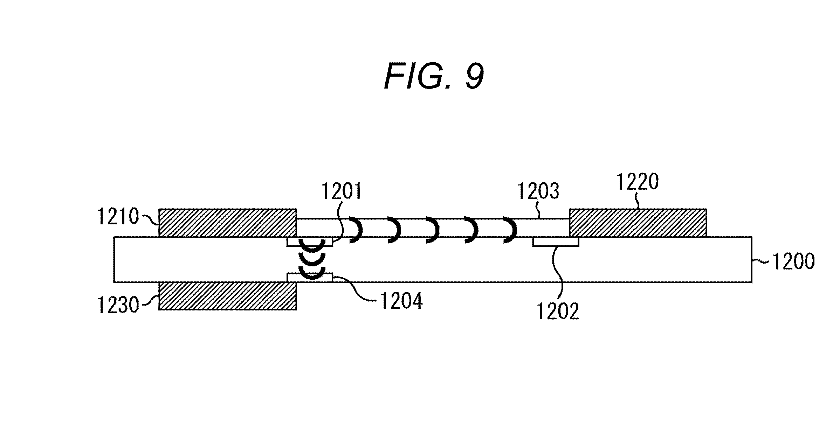

Fig. 9 is a cross-sectional view illustrating a second example of the arrangement of a chip configuring the electronic apparatus.

Note that in Fig. 9, a part corresponding to the one in Fig. 8 is assigned with the same reference numeral so that the description of the part will be omitted as appropriate.

Similar to Fig. 8, the substrate 1200 in Fig. 9 includes the couplers 1201 and 1202, the plastic waveguide 1203, and the chips 1210 and 1220 that are provided on the front surface.

A chip 1230 is further mounted on the back surface of the substrate 1200 as illustrated in Fig. 9.

The chip 1230 includes an input/output circuit (not shown) having the same configuration as the input/output circuit 1 (Fig. 1), and a coupler 1204 similar to the coupler 1101 (Fig. 8) such as an antenna is connected to a portion corresponding to the pads 103 and 211 (Fig. 1) of the input/output circuit to efficiently radiate the millimeter wave to the free space and the dielectric waveguide.

Note that in Fig. 9, the chip 1210 on the front surface and the chip 1230 on the back surface of the substrate 1200 are arranged such that the couplers 1201 and 1204 face each other.

Similar to the case in Fig. 8, as described above, the electronic apparatus in which the chips 1210, 1220, and 1230 are arranged performs data transmission by exchanging the millimeter wave between the chips 1210 and 1220 on the front surface of the substrate 1200 through the plastic waveguide 1203.

Moreover, the chip 1210 on the front surface and the chip 1230 on the back surface of the substrate 1200 perform data transmission by exchanging the millimeter wave through the substrate 1200 serving as the free space (or the substrate 1200 as a dielectric waveguide where the substrate 1200 is regarded as the dielectric waveguide).

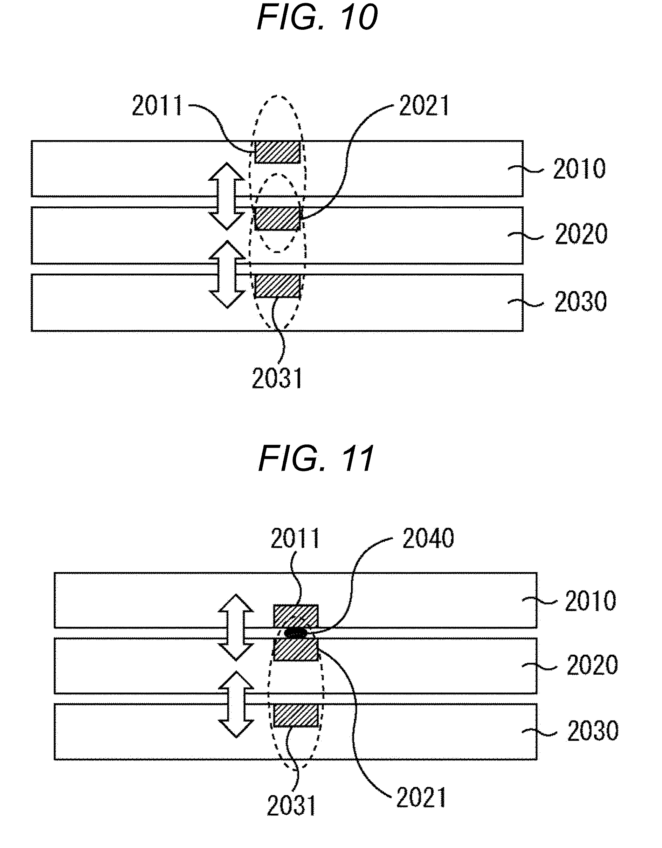

Fig. 10 is a cross-sectional view illustrating a third example of the arrangement of a chip configuring the electronic apparatus.

As illustrated in Fig. 10, flat chips 2010, 2020, and 2030 are arranged while stacked in this order from the top.

The chips 2010, 2020, and 2030 include input/output circuits 2011, 2021, and 2031, respectively, where each input/output circuit has the same configuration as the input/output circuit 1 (Fig. 1).

A coupler (not shown) such as an antenna is connected to a portion corresponding to the pads 103 and 211 (Fig. 1) (hereinafter referred to as an input/output pad) of each of the input/output circuits 2011, 2021, and 2031 to efficiently radiate the millimeter wave to the free space and the dielectric waveguide.

Here, the input/output pad of the input/output circuit 2011 is exposed on a surface of the flat chip 2010. The surface of the chip 2010 on which the input/output pad is exposed is hereinafter also referred to as an exposed surface.

In Fig. 10, the chips 2010, 2020, and 2030 are stacked while the exposed surfaces thereof face upward in the figure.

When data transmission is to be performed between the chips 2010 and 2020 and between the chips 2020 and 2030, for example, it is difficult to form the metallic wire or the dielectric waveguide between the chips 2010 and 2020 and between the chips 2020 and 2030 as the exposed surface of each of the chips 2010, 2020, and 2030 faces upward.

Accordingly, the data transmission between the chips 2010 and 2020 (between the input/output circuits 2011 and 2021) and between the chips 2020 and 2030 (between the input/output circuits 2021 and 2031) in Fig. 10 is performed by exchanging the millimeter wave through the free space.

Fig. 11 is a cross-sectional view illustrating a fourth example of the arrangement of a chip configuring the electronic apparatus.

Note that in Fig. 11, a part corresponding to the one in Fig. 10 is assigned with the same reference numeral so that the description of the part will be omitted as appropriate.

Similar to the case in Fig. 10, the flat chips 2010, 2020, and 2030 are arranged while stacked in this order from the top as illustrated in Fig. 11.

In Fig. 11, however, the exposed surfaces of the chips 2020 and 2030 face upward as is the case with Fig. 10, whereas the exposed surface of the chip 2010 faces downward in the figure.

Moreover, the input/output pad (of the input/output circuit 2011) on the chip 2010 and the input/output pad (of the input/output circuit 2021) on the chip 2020 face each other and are connected via a bump (an electrode) 2040 serving as the metallic wire.

In Fig. 11, data transmission between the chips 2010 and 2020 is performed by exchanging the millimeter wave through the bump 2040 serving as the metallic wire, whereas data transmission between the chips 2020 and 2030 is performed by exchanging the millimeter wave through the free space.

### [Method of testing chip]

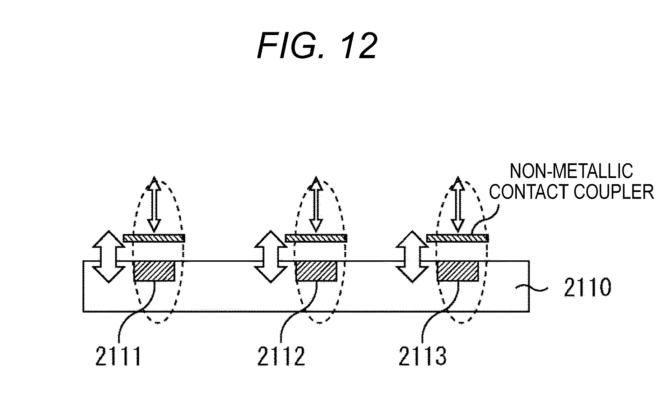

Fig. 12 is a cross-sectional view illustrating a method of testing the operation of a chip including an input/output circuit that has the same configuration as the input/output circuit 1 (Fig. 1).

As illustrated in Fig. 12, a chip 2110 includes input/output circuits 2111, 2112, and 2113 each having the same configuration as the input/output circuit 1 (Fig. 1).

Moreover, as illustrated in Fig. 12, an upward-facing surface out of two surfaces of the flat chip 2110 corresponds to an exposed surface on which an input/output pad of each of the input/output circuits 2111, 2112, and 2113 is exposed.

A signal exchange with each of the input/output circuits 2111, 2112, and 2113 is required in order to test the operation of the chip 2110.

There is a method of exchanging a signal with each of the input/output circuits 2111, 2112, and 2113 by bringing a measuring probe (metal) into contact with the input/output pad of each of the input/output circuits 2111, 2112, and 2113 and measuring a signal exchanged with each of the input/output circuits 2111, 2112, and 2113 through the probe, for example.

However, the input/output pad may be damaged when the probe is brought into contact with the input/output pad of each of the input/output circuits 2111, 2112, and 2113.

Accordingly, in testing the input/output circuits 2111, 2112, and 2113, a non-metallic contact coupler is used to exchange a signal with each of the input/output circuits 2111, 2112, and 2113 through the free space so that the signal exchanged with each of the input/output circuits 2111, 2112, and 2113 can be measured without physically contacting the input/output pad.

In the case illustrated in Fig. 12, the non-metallic contact coupler is brought close to the exposed surface of the chip 2110 to exchange a signal between the non-metallic contact coupler and each of the input/output circuits 2111, 2112, and 2113.

Each of the input/output circuits 2111, 2112, and 2113 having the same configuration as the input/output circuit 1 (Fig. 1) can use any of the free space, the dielectric waveguide, and the metallic wire as the transmission medium and can therefore use the free space as the transmission medium to be able to perform a non-invasive test, namely, a test by which the input/output pad is not damaged.

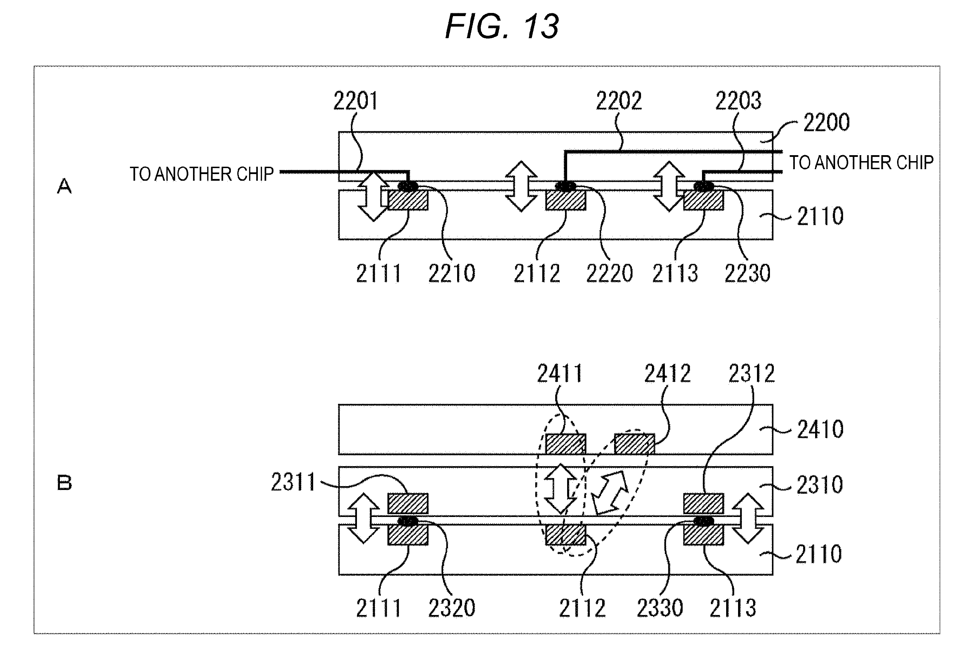

Figs. 13A and 13B are cross-sectional views illustrating the implementation of the chip 2110 in Fig. 12 after the non-invasive test is performed.

Fig. 13A is the cross-sectional view illustrating an example of how the chip 2110 is implemented with the use of an interposer.

As illustrated in Fig. 13A, the chip 2110 and an interposer 2200 are arranged to be stacked on top of each other.

Metallic wires 2201, 2202, and 2203 are wired inside the interposer 2200, and one ends of the metallic wires 2201, 2202, and 2203 are connected to bumps 2210, 2220, and 2230, respectively, that are provided on one surface of the flat interposer 2200.

The interposer 2200 is stacked such that the bumps 2210, 2220, and 2230 are connected to input/output pads of the input/output circuits 2111, 2112, and 2113, respectively.

The input/output circuit 2111 performs data transmission with another chip (a chip other than the chip 2110) through the bump 2210 and the metallic wire 2201. Likewise, the input/output circuit 2112 performs data transmission with another chip through the bump 2220 and the metallic wire 2202, and the input/output circuit 2113 performs data transmission with another chip through the bump 2230 and the metallic wire 2203.

Fig. 13B is the cross-sectional view illustrating an example of how the chip 2110 is implemented without using the interposer.

As illustrated in Fig. 13B, flat chips 2110, 2310, and 2410 are arranged to be stacked in this order from the bottom.

The chip 2310 includes input/output circuits 2311 and 2312 each having the same configuration as the input/output circuit 1 (Fig. 1).

The chip 2410 includes input/output circuits 2411 and 2412 each having the same configuration as the input/output circuit 1 (Fig. 1).

In the case illustrated in Fig. 13B, the chips are stacked such that the exposed surface of the chip 2110 faces upward, an exposed surface of the chip 2310 faces downward, and an exposed surface of the chip 2410 faces downward.

Moreover, the input/output pad of the input/output circuit 2111 on the chip 2110 and an input/output pad of the input/output circuit 2311 on the chip 2310 are arranged to face each other and connected via a bump 2320 serving as the metallic wire.

Moreover, the input/output pad of the input/output circuit 2113 on the chip 2110 and an input/output pad of the input/output circuit 2312 on the chip 2310 are arranged to face each other and connected via a bump 2330 serving as the metallic wire.

Data transmission is performed between the input/output circuit 2111 on the chip 2110 and the input/output circuit 2311 on the chip 2310 by exchanging the millimeter wave through the bump 2320 serving as the metallic wire.

Likewise, data transmission is performed between the input/output circuit 2113 on the chip 2110 and the input/output circuit 2312 on the chip 2310 by exchanging the millimeter wave through the bump 2330 serving as the metallic wire.

Moreover, data transmission is performed between the input/output circuit 2112 on the chip 2110 and each of the input/output circuits 2411 and 2412 on the chip 2410 by exchanging the millimeter wave through the free space.

Note that the data transmission between the input/output circuit 2112 on the chip 2110 and each of the input/output circuits 2411 and 2412 on the chip 2410 can be performed such that the data is broadcast from the input/output circuit 2112 to both of the input/output circuits 2411 and 2412, or transmitted between the input/output circuits 2112 and 2411 and between the input/output circuits 2112 and 2412 independently.

The data transmission can be performed independently between the input/output circuit 2112 on the chip 2110 and the input/output circuit 2411 on the chip 2410 and between the input/output circuits 2112 and 2412 by a method where the data is transmitted by means of frequency division such that the carrier frequency of the millimeter wave used in the data transmission between the input/output circuits 2112 and 2411 is set to a value different from the carrier frequency of the millimeter wave used in the data transmission between the input/output circuits 2112 and 2412, for example. Another method of performing the data transmission independently between the input/output circuits 2112 and 2411 and between the input/output circuits 2112 and 2412 is to perform data transmission by means of time division or code division, for example.

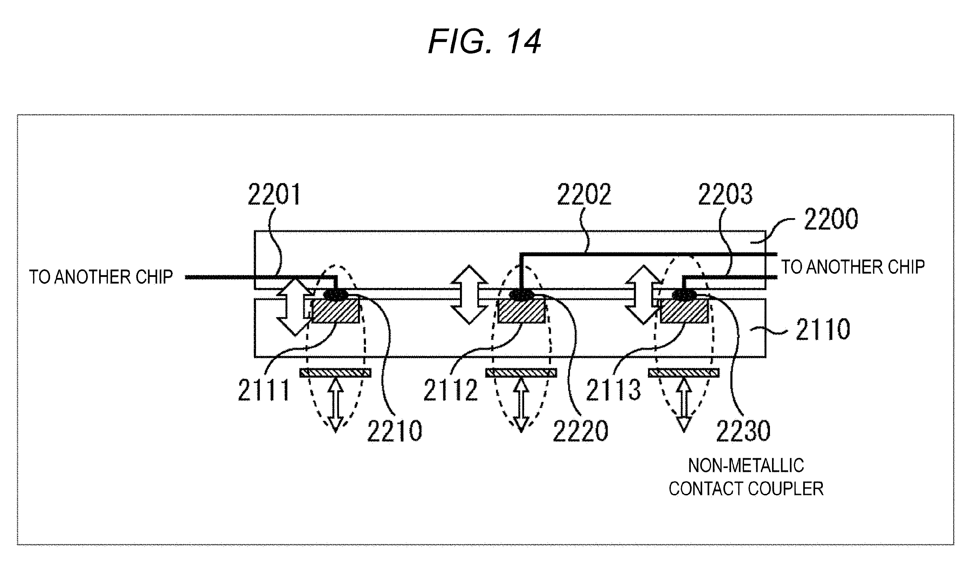

Fig. 14 is a cross-sectional view illustrating a method of testing the chip 2110 after being implemented.

In other words, Fig. 14 illustrates the chip 2110 after the implementation where the interposer 2200 is stacked as illustrated in Fig. 13A.

In the case illustrated in Fig. 14, a non-metallic contact coupler is brought close to a surface of the chip 2110 opposite to the exposed surface thereof so that a signal is exchanged between the non-metallic contact coupler and each of the input/output circuits 2111, 2112, and 2113.

Each of the input/output circuits 2111, 2112, and 2113 having the same configuration as the input/output circuit 1 (Fig. 1) can use any of the free space, the dielectric waveguide, and the metallic wire as the transmission medium, so that the non-metallic contact coupler receives a signal leaking, so to speak, to the free space serving as the transmission medium from the input/output pad of each of the input/output circuits 2111, 2112, and 2113 to be able to test the operation of the chip 2110 after the implementation where the input/output pad is not exposed due to the interposer 2200 being stacked.

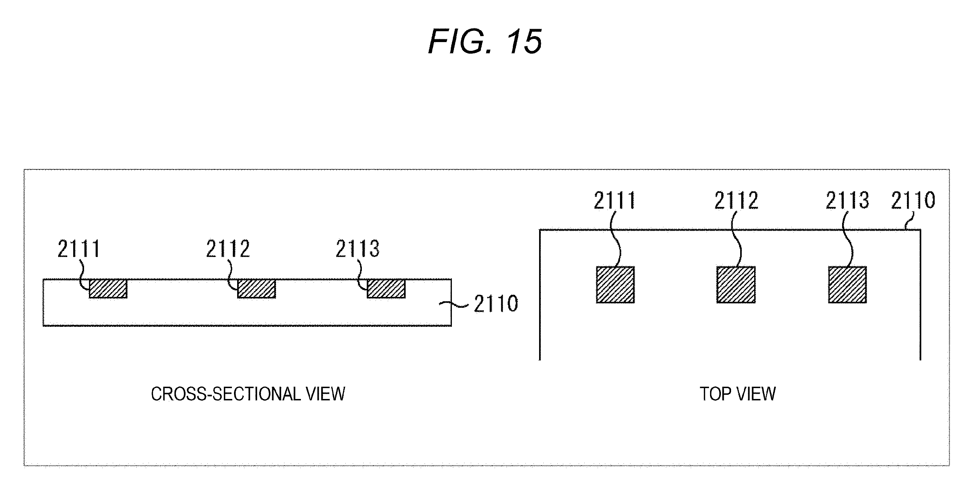

Figs. 15 to 17 are diagrams each illustrating a method of performing a loop-back test on the chip 2110 illustrated in Fig. 12.

Fig. 15 illustrates a cross-sectional view of the chip 2110 and a top view thereof when the exposed surface corresponds to a top surface.

Now, it is assumed that the loop-back test is performed by transmitting a signal from the input/output circuit 2112 and receiving the signal by the input/output circuits 2111 and 2113, for example.

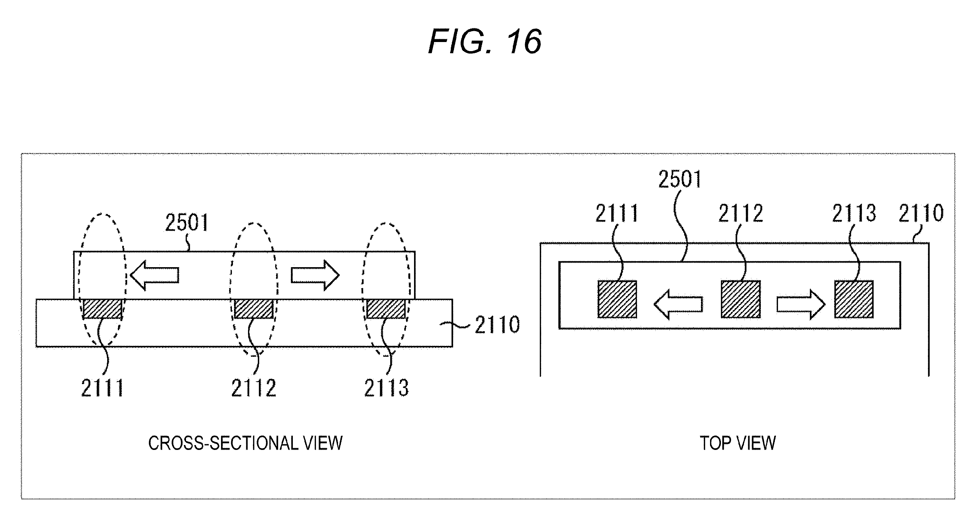

Fig. 16 is the diagram illustrating a method of performing the loop-back test in which the signal transmitted from the input/output circuit 2112 is received by both of the input/output circuits 2111 and 2113.

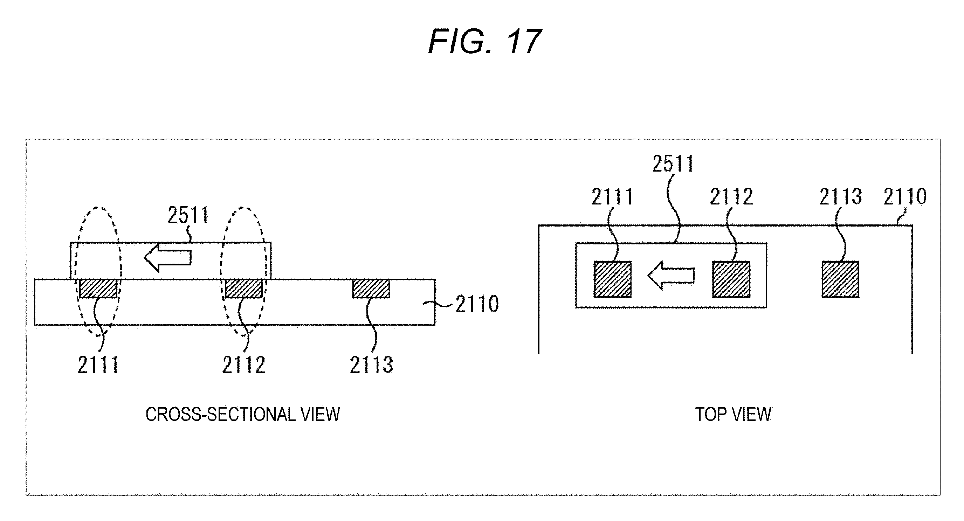

Note that Fig. 16 (and Fig. 17 to be described below) illustrates the cross-sectional view and the top view of the chip 2110.

When the signal transmitted from the input/output circuit 2112 is received by both of the input/output circuits 2111 and 2113, a strip of dielectric material 2501 is arranged as the dielectric waveguide covering the input/output pad of all the input/output circuits 2111, 2112, and 2113, as illustrated in Fig. 16.

As a result, the signal transmitted from the input/output circuit 2112 is received by each of the input/output circuits 2111 and 2113 through the dielectric material 2501.

Note that an antenna with the length 1/2 or shorter than the wavelength λ of the signal transmitted from the input/output circuit 2112 is connected to the input/output pad of each of the input/output circuits 2111, 2112, and 2113 so that, when the dielectric material 2501 with a large dielectric constant is arranged, the wavelength of the signal transmitted from the input/output circuit 2112 becomes equivalently shorter in order for the signal to be efficiently transmitted/received between the input/output circuit 2112 and each of the input/output circuits 2111 and 2113.

Fig. 17 is the diagram illustrating a method of performing the loop-back test in which the signal transmitted from the input/output circuit 2112 is received only by the input/output circuit 2111 out of the input/output circuits 2111 and 2113, for example.

When the signal transmitted from the input/output circuit 2112 is received only by the input/output circuit 2111, a strip of dielectric material 2511 is arranged as the dielectric waveguide covering only from the input/output pad of the input/output circuit 2111 to the input/output pad of the input circuit 2112, as illustrated in Fig. 17.

As a result, the signal transmitted from the input/output circuit 2112 is received only by the input/output circuit 2111 through the dielectric material 2511.

The loop-back test can be performed by just arranging the dielectric material 2501 or 2511 as described above.

Note that the embodiments of the present technology are not limited to what is described above but can be modified in various ways without departing from the scope of the present technology.

That is, the RF signal used in the data transmission by the input/output circuit 1 (Fig. 1) is not limited to the millimeter wave, for example.

Note that the present technology can be configured as follows.
[1] A signal processing device comprising a plurality of signal processing circuits, wherein
   the signal processing circuit includes an input/output circuit configured by one or both of an input circuit which functions as an input interface of a signal occupying a predetermined frequency band, and an output circuit which functions as an output interface of a signal occupying the predetermined frequency band,
   the signal occupying the predetermined frequency band is transmitted between the signal processing circuit and another signal processing circuit,
   each of the output circuit of one signal processing circuit and the output circuit of another signal processing circuit includes a circuit having the same configuration,
   each of the input circuit of the one signal processing circuit and the input circuit of the another signal processing circuit includes a circuit having another same configuration, and
   the signal occupying the predetermined frequency band can be transmitted between the input/output circuit of the one signal processing circuit and the input/output circuit of the another signal processing circuit through any of a plurality of transmission media each having a different characteristic.
[2] The signal processing device according to [1], wherein the signal occupying the predetermined frequency band is a signal in a millimeter wave band.
[3] The signal processing device according to [2], wherein
   the circuit having the same configuration is a conversion circuit which converts a baseband signal to a signal in the millimeter wave band, and
   the circuit having the another same configuration is an inverse conversion circuit which converts the signal in the millimeter wave band back to the baseband signal.
[4] The signal processing device according to any of [1] to [3], wherein the plurality of transmission media each having the different characteristic is a plurality of different types of transmission media.
[5] The signal processing device according to [4], wherein the plurality of different types of transmission media corresponds to two or more of free space, a dielectric waveguide, and a metallic wire.
[6] The signal processing device according to any of [1] to [5] wherein, among the plurality of signal processing circuits, at least a pair of the signal processing circuits performs transmission of the signal occupying the predetermined frequency band through the transmission medium having a predetermined characteristic, while at least another pair of the signal processing circuits performs transmission of the signal occupying the predetermined frequency band through the transmission medium having a characteristic different from the predetermined characteristic.
[7] The signal processing device according to any of [1] to [6], wherein the signal processing circuit includes a plurality of the input/output circuits.
[8] The signal processing device according to any of [1] to [7], wherein a pair of the signal processing circuits which performs transmission of the signal occupying the predetermined frequency band is provided on another substrate.

### REFERENCE SIGNS LIST

- 1, 2: Input/output circuit
- 71ᵢ: Oscillator
- 72ᵢ: Mixer
- 73i, 81ᵢ: Amplifier
- 82ᵢ: Oscillator
- 83ᵢ: Mixer
- 100: Output circuit
- 101₁ to 101_{N}: Transmission unit
- 102: Multiplexer
- 103: Pad
- 110: Input circuit
- 200: Output circuit
- 210: Input circuit
- 211: Pad
- 212: Multiplexer
- 213₁ to 213_{N}: Reception unit
- 300: Substrate
- 310: Chip
- 311, 312: Input/output circuit
- 320: Chip
- 321: Input/output circuit
- 400: Substrate
- 410: Chip
- 411 to 415: Input/output circuit
- 420: Chip
- 421: Input/output circuit
- 430: Chip
- 431: Input/output circuit
- 440: Chip
- 441: Input/output circuit
- 1100: Substrate
- 1101: Coupler
- 1110: Chip
- 1200: Substrate
- 1201, 1202: Coupler
- 1203: Plastic waveguide
- 1204: Coupler
- 1210, 1220, 1230: Chip
- 2010: Chip
- 2011: Input/output circuit
- 2020: Chip
- 2021: Input/output circuit
- 2030: Chip
- 2031: Input/output circuit
- 2040: Bump
- 2110: Chip
- 2111, 2112, 2113: Input/output circuit
- 2200: Interposer
- 2201, 2202, 2203: Metallic wire
- 2210, 2220, 2230: Bump
- 2310: Chip
- 2311, 2312: Input/output circuit
- 2320, 2330: Bump
- 2410: Chip
- 2411, 2412: Input/output circuit

## Claims

1. A signal processing device comprising a plurality of signal processing circuits, wherein
the signal processing circuit includes an input/output circuit configured by one or both of an input circuit which functions as an input interface of a signal occupying a predetermined frequency band, and an output circuit which functions as an output interface of a signal occupying the predetermined frequency band,
the signal occupying the predetermined frequency band is transmitted between the signal processing circuit and another signal processing circuit,
each of the output circuit of one signal processing circuit and the output circuit of another signal processing circuit includes a circuit having the same configuration,
each of the input circuit of the one signal processing circuit and the input circuit of the another signal processing circuit includes a circuit having another same configuration, and
the signal occupying the predetermined frequency band can be transmitted between the input/output circuit of the one signal processing circuit and the input/output circuit of the another signal processing circuit through any of a plurality of transmission media each having a different characteristic.

2. The signal processing device according to claim 1, wherein the signal occupying the predetermined frequency band is a signal in a millimeter wave band.

3. The signal processing device according to claim 2, wherein
the circuit having the same configuration is a conversion circuit which converts a baseband signal to a signal in the millimeter wave band, and
the circuit having the another same configuration is an inverse conversion circuit which converts the signal in the millimeter wave band back to the baseband signal.

4. The signal processing device according to claim 3, wherein the plurality of transmission media each having the different characteristic is a plurality of different types of transmission media.

5. The signal processing device according to claim 4, wherein the plurality of different types of transmission media corresponds to two or more of free space, a dielectric waveguide, and a metallic wire.

6. The signal processing device according to claim 4 wherein, among the plurality of signal processing circuits, at least a pair of the signal processing circuits performs transmission of the signal occupying the predetermined frequency band through the transmission medium having a predetermined characteristic, while at least another pair of the signal processing circuits performs transmission of the signal occupying the predetermined frequency band through the transmission medium having a characteristic different from the predetermined characteristic.

7. The signal processing device according to claim 4, wherein the signal processing circuit includes a plurality of the input/output circuits.

8. The signal processing device according to claim 4, wherein a pair of the signal processing circuits which performs transmission of the signal occupying the predetermined frequency band is provided on another substrate.
